**Europäisches Patentamt**

**European Patent Office**

**Office européen des brevets**

(11) Publication number: **0 080 342**
A2

# EUROPEAN PATENT APPLICATION

(21) Application number: **82306171.8**

(22) Date of filing: **19.11.82**

(51) Int. Cl.³: **H 01 L 31/18, H 01 L 31/06**

(30) Priority: **20.11.81 US 323225**

(43) Date of publication of application: **01.06.83**
**Bulletin 83/22**

(84) Designated Contracting States: **DE FR GB NL**

(71) Applicant: **EASTMAN KODAK COMPANY, Patent Department 343 State Street, Rochester, New York 14650 (US)**

(72) Inventor: **Lin, Alice Wei-Lung Lee, 22782 Caseda, Mission Viejo California 92691 (US)**
Inventor: **Raychaudhuri, Pranab Kumar, 147 Jay Vee Lane, Rochester New York 14612 (US)**

(74) Representative: **Pepper, John Herbert et al, KODAK LIMITED Patent Department P.O. Box 114 190 High Holborn, London WC1V 7EA (GB)**

(54) **A photosensitive element, a method of preparing the element and a photovoltaic cell comprising the element.**

(57) A photosensitive element comprises a support (12) bearing a low-resistance contact electrode and a layer of n-type or p-type CdTe (20) on the electrode. The electrode, the CdTe layer or both thereof comprise a dopant for the CdTe and the electrode further comprises an oxidized metal, the reduced form of the metal being capable of reducing the oxidized form of the dopant. The element may be produced in thin film format whereon the CdTe is vapor deposited. The element is particularly suitable for preparing photovoltaic cells.

EP 0 080 342 A2

ACTORUM AG

## A PHOTOSENSITIVE ELEMENT, A METHOD OF PREPARING THE ELEMENT AND A PHOTOVOLTAIC CELL COMPRISING THE ELEMENT

The invention relates to a photosensitive element comprising a support bearing an electrically conductive electrode and a layer of n-type or p-type CdTe on the electrode. A method of preparing the element is provided. The element is particularly suitable for use in a photovoltaic cell wherein the layer of n-type or p-type CdTe is sandwiched between the electrode of the element and a barrier electrode comprising a metal forming a photovoltaically active junction with the CdTe layer.

Schottky barrier solar cells advantageously comprise a layer of n-type CdTe to which is secured a barrier electrode and an ohmic-contact electrode forming a low-resistance contact to the CdTe layer. As used herein, "low-resistance contact" refers to a contact resistance equal to or less than about 20 ohm-cm$^2$. To reduce the cost of manufacturing such cells, a procedure has been sought for coating the various layers in thin film format, e.g., as by depositing them from the vapor phase onto an electrode. Vapor deposition of the materials of the cell provides an inexpensive process for making the cells.

However, there remain problems in the use of this technique. CdTe can be deposited from the vapor phase onto the low-resistance contact electrode, or the low-resistance contact electrode can be deposited onto the CdTe layer. The latter technique is disadvantageous because the CdTe layer, in turn, has to be first deposited on the barrier electrode. Such a process does not permit prior heat-treatment of the CdTe layer in the portion that is to contact the barrier electrode. The photovoltaic cells of U.S. Patent 4,035,197 achieve remarkably high efficiencies by the step of heating, in an oxygen-containing atmosphere, the surface of the CdTe that is contacted subsequently with the barrier electrode. To enable the use of such a heating process, the CdTe is deposited or coated onto the low-resistance contact electrode, rather than vice-versa.

However, depositing CdTe from the vapor phase onto the low-resistance contact electrode cannot be done with indium, one of the most common low-resistance contact electrodes for n-type CdTe, because of the low melting point of indium. That is, the high temperature used in depositing the CdTe destroys a thin layer of indium. More specifically, such a temperature is high enough to cause the indium layer to melt and ball up into isolated globules. Attempts to avoid the destruction of the layer by coating a very thin layer of indium have resulted in a self-maintaining layer which, nevertheless, is unsatisfactory because it readily oxidizes. Until the present invention, oxides of indium have interfered with the formation of the desired electrode. The conventional procedure of using a molybdenum support coated with n-type CdS as an electrode for CdTe heterojunction solar cells is undesirably expensive.

The present invention overcomes the drawbacks of the prior art by providing a relatively inexpensive photosensitive element comprising a support bearing an electrode which forms a low-resistance contact to a layer of n-type or p-type CdTe on the electrode wherein the CdTe may be vapor deposited.

A particular advantage of the invention is that it provides a photosensitive element comprising CdTe and a low-resistance contact electrode for the CdTe that permits vapor deposition of the CdTe without requiring expensive pretreatment of the electrode.

It is another particular advantage of the present invention that the materials and construction of such electrode are inexpensive compared to conventional techniques used before this invention, and yet are suitable for making an integrated array.

The photosensitive element of the invention comprises a support bearing an electrically conductive electrode and a layer of n-type or p-type CdTe on the electrode,

characterized in that said electrode, said CdTe layer or both thereof comprise

a) a material having an electronically active form capable of functioning as an n-type or p-type dopant for said n-type or p-type CdTe, respectively, and said electrode comprises

b) an oxidized metal or reaction product thereof which, in reduced form, is capable of reducing the oxidized form of said material to said electronically active form,

said electrode having, with said CdTe layer, a contact resistance that is no greater than about 20 $ohm-cm^2$.

Thus, the advantages of the invention are achieved by providing an electrode structure that comprises an oxidized metal or reaction product thereof and by providing in the electrode or the CdTe layer or both thereof, an electronically active form of a material that acts as a dopant for the CdTe.

Optionally, the electrode also includes at least one of the reduced form of the oxidized metal and the oxidized form of the material, wherein the reduced form of the metal is capable of reducing the oxidized form of the material to form the dopant.

Preferably, said electrode includes a first layer comprising said oxidized form of said material and a second layer comprising said reduced form of said metal, one of said layers being in contact with said CdTe layer,

said layers including an interfacial region comprising said electronically active form of said material and said oxidized metal. The oxidized form of the material in the first layer is preferably the oxide of the material.

Preferably, the CdTe is n-type and the material is an element selected from In, Ga, B, Tl, Al and Cd.

Preferably, the metal is titanium, chromium, zirconium, aluminum, hafnium, tantalum or magnesium.

In a particularly preferred embodiment of the invention, the electrode comprises an admixture of indium, oxidized titanium, and titanium.

A photovoltaic cell may be produced having the features of the aforesaid low-resistance contact electrode. Such a cell comprises this electrode and a barrier electrode, with the CdTe layer sandwiched between the two electrodes.

More specifically, the photovoltaic cell comprises a layer of n-type or p-type CdTe sandwiched between an electrically conductive electrode on a support and a barrier electrode comprising a metal forming a photovoltaically active junction with said CdTe layer, wherein the layer of n-type or p-type CdTe and the electrically conductive electrode on a support form a photosensitive element of the present invention.

A method of producing a photosensitive element of the invention comprises

a) (i) forming two layers on a support, one of said layers comprising an oxidized material which, in reduced form, is electronically active to function as an n-type or p-type dopant for said n-type or p-type CdTe, respectively; and the other layer comprising a metal capable of reducing said oxidized material to said reduced form, or

  (ii) forming a layer on a support, said layer comprising a mixture of said oxidized material and said metal, and

  b) forming on said layers or layer, a layer of n-type or p-type CdTe.

  Preferably, said steps include

  c) heating said layer or layers and said CdTe layer at a temperature and for a time sufficient to reduce at least some of said oxidized material to said reduced form and to diffuse at least some of said reduced form of said material into said CdTe layer.

  The electrode described herein is preferably used as a low-resistance contact electrode for a photovoltaic cell of the Schottky barrier type, featuring CdTe as the semiconductor material. Such electrode is also useful in any photosensitive element requiring a low-resistance contact electrode. For example, such an electrode can be used to manufacture homojunction, MIS and heterojunction solar cells, as well as a photosensitive element useful in electrophotographic imaging. In the case of a photosensitive element for electrophotographic imaging, only one electrode, the low-resistance contact electrode, is necessary.

  The preferred embodiments of the invention are particularly described in connection with n-type CdTe semiconductor material. The invention is also useful in making low-resistance contact to p-type CdTe material, the dopant in such case being, for example, phosphorus, antimony, or arsenic.

  Because a dopant for the CdTe layer is produced in the electrode, an improved low-resistance contact is made with the CdTe layer. It has been found that the production of the dopant is readily achieved by creating an oxidation-reduction reaction between the oxidized form of the material that becomes the dopant, and a metal capable of reducing the oxidized material to its reduced form. Preferably the oxidized material and the metal are present as two layers, and the oxidation-reduction reaction takes place at least in an interfacial region between the layers to form the reduced, electronically active form of the material. As used herein, "electronically active" refers to that oxidation state of the material, having an energy level falling within the band gap of the CdTe semiconductor, that properly dopes that CdTe semiconductor. It is believed that this oxidation state in most cases is the elemental form of the material, e.g., $In^0$ when indium is used as the dopant. The oxidized state does not appear to function as a dopant. Hence the preferred embodiments discussed hereinafter refer to the elemental dopant as the oxidation state believed to be present for the electronically active form.

As noted hereinafter, the entire electrode can be constructed to be an admixture of the elemental dopant, the oxidized metal, and optionally either excess elemental metal not yet oxidized or excess oxidized dopant not yet reduced. For best electrical conductivity, those embodiments featuring an excess of elemental metal are preferred.

As used herein, "oxidized dopant" or "oxidized form" is an elemental dopant or material, respectively, modified so as to have a net positive charge such as is produced when the dopant or material is combined with an electro-negative element. Although the preferred form of the oxidized dopant or oxidized material is the oxide of the dopant or material, other forms are also useful, for example, halogenated dopants, e.g., $InCl_3$, and $GaBr_3$.

Useful dopants for n-type CdTe include indium, gallium, boron, aluminum, cadmium and thallium. Indium oxide is a particularly preferred oxidized dopant, and useful forms thereof include indium oxide vacuum deposited onto soda-lime glass, and glass coated with doped indium oxide as is available from PPG Industries under the trademark "Nesatron" glass.

Any metal that will reduce the oxidized dopant is useful as the reducing metal. Unexpectedly, even metals that normally form a barrier, rather than a low-resistance contact, to n-type CdTe, can be used as the metal without adversely affecting the low-resistance contact with n-type CdTe. For example, chromium has been found to be useful as the reducing metal when indium oxide is the dopant oxide. It is believed that such a variety of metals is useful because it is the dopant, rather than the metal, that causes the formation of the low-resistance contact with the n-type CdTe layer.

The capability of a particular metal to reduce the oxidized dopant is ascertained by examining the free energy of formation of the oxidized metal, measured on a per mole of anion basis. If such free energy is more negative than the corresponding free energy of formation of the oxidized dopant that is to be reduced, then reduction of the oxidized dopant is likely to occur.

As noted, the preferred oxidized form is the oxide. The following table lists the free energy of formation of some pertinent oxides. A metal is a satisfactory reducing metal if its oxide is higher on the list than the dopant oxide to be reduced.

0080342

## Table I

| Compound | $-\Delta G^{\circ}_{298}$, kcal/g atom of oxygen |
|---|---|
| MgO | 136.1[a] |
| $Al_2O_3$ | 126.1[b] |
| $ZrO_2$ | 124.6[c] |
| $HfO_2$ | 122.7[c] |
| $TiO_2$ | 106.3[c] |
| $Ta_2O_5$ | 91.4[c] |
| $Cr_2O_3$ | 84.3[d] |
| $Ga_2O_3$ | 79.5[b] |
| ZnO | 76.1[b] |
| $In_2O_3$ | 66.2[b] |
| $SnO_2$ | 62.1[b] |
| FeO | 60.1[f] |
| CdO | 54.6[b] |
| CoO | 51.2[d] |
| NiO | 50.6[d] |
| PbO | 44.9[b] |
| $TeO_2$ | 32.3[b] |
| CuO | 31.0[d] |
| $Ag_2O$ | 2.68[d] |
| $Au_2O_3$ | -13.0[e] |

a) NBS Technical Note (270-6), 1971.

b) NBS Technical Note (270-3), 1968.

c) NBS Technical Note (270-5), 1971.

d) NBS Technical Note (270-4), 1969.

e) NBS Circular 500, 1952.

f) JANAF Thermochemical Tables, 2d Ed.,
NSRDS-NBS-37 (1971)

For some oxides, the free energy of formation is not readily ascertainable. In that event, the heats of formation may be compared on the same basis i.e. a metal will reduce the dopant oxide if the heat of formation of the oxide of the metal is more negative than that of the dopant oxide.

In accordance with the invention, metals particularly useful to reduce dopant oxides such as $In_2O_3$ or $Ga_2O_3$ include titanium, chromium, zirconium, aluminum, hafnium, tantulum and magnesium.

It is believed that it is the elemental form of the dopant that causes the electrode to produce a low-resistance contact with the CdTe. It is further believed that the elemental dopant forms during the oxidation-reduction reaction and migrates from the interfacial region to the CdTe layer. Some oxidized metal or reaction product thereof is believed also to be present, at least in the interfacial region. Examples of possible reaction products of the oxidized metal include metal telluride and products produced by a reaction with anions from the support, if the support is glass.

For example, if the oxidized dopant is $In_2O_3$ and the metal is titanium, after the redox reaction the interfacial region preferably comprises primarily indium and titanium oxide.

In some instances, and particularly those in which the layer of oxidized dopant is very thin, substantially all the oxidized dopant in that layer is reduced to elemental dopant during the preparation of the element. In that case, the electrode comprises the elemental dopant, the oxidized metal, and remaining excess metal which is not oxidized.

Any support is useful for the photosensitive element, including conductive supports such as aluminum, steel and graphite and insulative supports such as glass, ceramic, and quartz. Insulative supports, that is, those that are electrically non-conductive, advantageously permit the element to be constructed as an integrated array of elements on a single support, each element being insulated from the others except where deliberately connected to form the desired circuit. Therefore, a preferred insulative support is glass, for example, "Nesatron" or soda-lime glass.

The completed photosensitive element comprises such a support, the electrode structure previously described, and a layer of CdTe semiconductor material. Preferably the CdTe is in polycrystalline form.

To complete a photovoltaic cell, a preferred embodiment of the invention, a barrier electrode is added to sandwich the CdTe layer between the two electrodes. The barrier electrode is selected to form a photovoltaically active junction with the layer of CdTe. Such electrodes are conventional, and examples for use with n-type CdTe include a thin, semi-transparent coating of gold, silver, copper, platinum, nickel, chromium, and palladium.

Preferably, a photosensitive element of the invention is prepared by depositing the various layers from the vapor phase. Conventional deposition in a high vacuum is preferred for the electrode formation, that is, in a vacuum of $133 \times 10^{-5}$Pa ($10^{-5}$ torr). The materials of the electrode described above may be deposited so that each form a layer that is quite thin. Useful thicknesses for the layers include, for the metal layer 0.02 to 0.4µm, (200 to 4000Å), most preferably 0.1µm (1000Å), and 0.0025 to 0.4µm (25 to 4000Å) for the oxidized dopant layer, most preferably 0.01µm (100Å). Thus the interfacial region has a thickness resulting from the reduction of either all or part of the oxidized dopant layer; that is, the thickness is from less than $10^{-4}\mu m$ (1Å) up to $0.0025\mu m$ (25Å) or more.

The order of deposition of the two layers is generally not critical. That is, the photosensitive element is useful whether the oxidized dopant layer is in contact with the support or with the CdTe layer. However, if the reducing metal layer is deposited first, so that the layer of oxidized dopant is formed on the metal, care should be taken to minimize the formation on the metal of a surface of oxide before the oxidized dopant is deposited. Otherwise the desired oxidation-reduction reaction is likely to be inhibited, especially if the metal is aluminum. Preferably, the undesired formation of oxide is avoided by vapor depositing both layers in a high vacuum, such as $133 \times 10^{-9} Pa$ ($10^{-9}$ torr), in a single pump-down.

Alternatively, both the oxidized dopant and the metal may be vapor deposited simultaneously. Usually, this will result in forming a first layer on the support of the material having the higher vapor pressure, followed by a layer of the material having the lower vapor pressure. By careful selection of materials and conditions, it is also possible to vapor deposit both the oxidized dopant and the metal in a generally homogeneous mixture, preferably with excess amounts of metal. In the latter case, the oxidation-reduction reaction produces an admixture of the elemental form of the dopant, the oxidized form of the metal, and excess metal not yet oxidized. Optionally, exact equivalent amounts of oxidized dopant and metal are selected so that neither excess unoxidized metal nor excess oxidized dopant remains after the oxidation-reduction reaction.

It is not essential that the electrode layers or layer so formed be heated to achieve the desired oxidation-reduction reaction and the desired dopant diffusion. These reactions occur to a certain extent at room temperature. If a heating step follows the step of formation of the electrode layer or layers, the oxidation-reduction reaction and dopant diffusion are accelerated. Preferably, such heating is derived from the heating used for the deposition of the CdTe layer, as described hereafter.

The deposition of the CdTe layer preferably occurs by a sublimation process at a pressure between $133 \times 10^{-6}$ and $133 \times 10^{2}$Pa ($10^{-6}$ and 100 torr), and most preferably at a pressure between $133 \times 10^{-5}$ and 1330Pa ($10^{-5}$ and 10 torr). The spacing between the CdTe source and the electrode preferably is between 0.5 and 30 mm. The CdTe is preferably deposited for a time of 0.1 sec to 10 minutes onto an electrode held at a preferred temperature of between 100°C and 700°C. As is customary in sublimation, the source temperature is maintained in each instance preferably between 10°C and 700°C higher than the electrode temperature. Conventional heating techniques for the source and/or the electrode include, e.g., resistance heating, induction heating and radiation heating.

The most preferred conditions for such sublimation are a vacuum of less than 13.3Pa (0.1 torr) and a laterally restricted space for the sublimation process. Specifically, a short, cylindrical, quartz tube is positioned between the source and the electrode with a length equal to the desired spacing between source and electrode. Both undoped CdTe and p- or n- type CdTe are useful as source material. The most preferred range for source temperatures is from 550°C to 800°C and for the electrode temperature, from 250°C to 550°C.

To complete a photovoltaic cell, the barrier electrode layer is applied by conventional techniques, for example vacuum deposition similar to that described for the other electrode. Alternatively, after deposition of the CdTe layer, and prior to deposition of the barrier electrode, the laminate is heat-treated in an oxygen-containing atmosphere in the manner described in U.S. Patent No. 4,035,197, whereby the open-circuit voltage of the cell is increased. A preferred form of such heat treatment is at a temperature between 250°C and 550°C and for a time of preferably between 0.5 and 5 minutes.

The invention is further illustrated by way of example in the accompanying drawings wherein:

Fig. 1 is a section view of a photovoltaic cell comprising a photosensitive element of the present invention; and

Figs. 2 and 3 are section views similar to that of Fig. 1 but illustrating alternative embodiments.

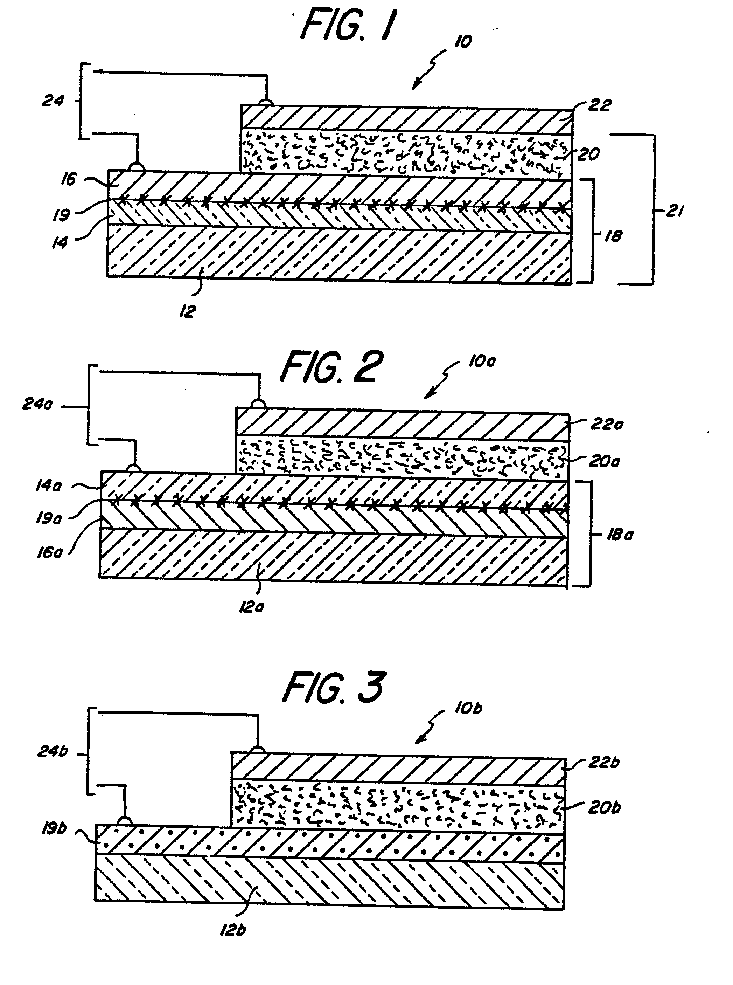

Fig. 1 illustrates a useful Schottky barrier photovoltaic cell 10 prepared in the manner described above. A glass support 12 has deposited on it layers 14 and 16, selected as described above to form a low-resistance contact electrode 18. For example, layer 14 is deposited as an oxide of a dopant, and layer 16 is deposited as a metal capable of reducing the dopant oxide. Interfacial region 19, represented by "x", Fig. 1, comprises the oxidation-reduction products of layers 14 and 16. On this electrode a layer 20 of polycrystalline n-type CdTe is deposited to form the photosensitive element 21.

The resulting photosensitive element provides a low-resistance contact to the CdTe layer of no greater than 20 ohm-cm$^2$. In the preferred embodiments, the resistance is less than 5 ohm-cm$^2$.

To convert element 21 into a photovoltaic cell, a suitable barrier electrode layer 22 is deposited over layer 20. To permit exposure of cell 10, layer 22 is preferably at least semi-transparent.

Wires or other suitable connectors 24 are soldered to each of the conductive layers 16 and 22, respectively, to connect the cell to a load or other electrical component. As with other Schottky barrier solar cells, such a cell is useful to generate electricity. Such uses are conventional and readily apparent to the skilled artisan.

Alternatively, wires 24 are omitted and a plurality of the cells are fabricated into an integrated, series-connected array using, e.g., the procedure described in U.S. Patent No. 3,713,893. A large glass sheet 12 provides a common support for the cells in such an embodiment.

In an alternative embodiment, not shown, layer 16 is deposited as two separate but contiguous layers, optionally of two different reducing metals.

In the embodiment of Fig. 2, the two layers of the electrode are reversed in their positions. Portions similar to those previously described bear the same reference numeral to which the distinguishing suffix "a" has been added. Thus, cell 10a comprises a support 12a, the two layers 14a and 16a, together with interfacial region 19a, comprising electrode 18a. A layer 20a of CdTe is disposed on layer 16a, and barrier electrode 22a completes the cell. Wires 24a allow connection of the cell to other electrical components. Unlike the previous embodiment, layer 16a of the reducing metal is in contact with support 12a, whereas layer 14a of the oxidized dopant contacts layer 20a.

In the embodiment 10b of Fig. 3, the electrode comprises a single admixture layer 19b, which after the oxidation-reduction reaction, comprises the elemental dopant, the oxidized metal, and optionally at least one of excess metal not oxidized and oxidized dopant not reduced. Layers 12b, 20b, 22b, and connectors 24b are as described for the other embodiments.

Preferred photovoltaic cells produced in the manner described above have conversion efficiencies which exceed 6% when measured under sunlight or simulated sunlight of 75 mW/cm$^2$ intensity.

Examples

The following examples further illustrate the invention.

Example 1

A photosensitive element of the invention was prepared from which a photovoltaic cell was prepared. First a layer of Ti, about 0.1μm (1000Å) thick was vacuum deposited on cleaned and degreased indium oxide-coated glass available under the trademark "Nesatron" glass from PPG Industries. Subsequently, a layer of n-CdTe about 50 μm thick was deposited over the Ti layer by the sublimation process described above using a vacuum of 2.66 Pa (2 X 10$^{-2}$ torr). The source of CdTe was an undoped, hot-pressed tablet, which was heated to 650°C by a radiation source during deposition. The temperature of the two-layer electrode during CdTe deposition was maintained at 330° to 410°C by a similar heat source, and the deposition continued for about 3.5 minutes. The resulting n-type CdTe film was heat-treated in air at 382°C for 3 minutes. The cell was completed by vacuum depositing a semi-transparent layer of Au which became the barrier electrode of the solar cell.

The performance of the solar cell was determined by measuring the current-voltage (I-V) relationship under illumination falling on the Au electrode and transmitted in part through that electrode. The shape of the I-V curve thus obtained was such that no current saturation in the forward-voltage direction was detected, indicating that the contact is ohmic with a resistance of less than 20 ohm-cm$^2$ between the CdTe and the electrode. Under an irradiance of 75 mW/cm$^2$ of simulated sunlight, the cell showed a conversion efficiency of 6.1 percent.

Example 2

A solar cell was prepared in a manner similar to that described in Example 1, except that the CdTe source additionally contained about 0.05 weight percent of $CdI_2$; the electrode temperature during CdTe deposition was approximately 335°C; the source temperature was 630°C; and the deposition time was 5 minutes. The resulting cell had a conversion efficiency of 7.1 percent when measured in the same manner as in Example 1.

Examples 3-10

For each of these examples, a cell was prepared using a glass support, a layer of dopant oxide as set forth in Table II, a layer of reducing metal as set forth in Table II, a layer of n-type CdTe and a gold barrier electrode about 100Å thick, all in the format of the cell of Fig. 1. Dopant oxides listed as "Nesatron" were obtained by using Nesatron glass supports and those designated as $In_2O_3$ were coated using a $133 \times 10^{-5}$ Pa ($10^{-5}$ torr) conventional vacuum evaporator (as were the other dopant oxides listed). The metal layers were coated using the same vacuum evaporator. The CdTe layer was about 25 μm thick, coated as in the procedure of Example 1 except that the source was heated to a temperature of about 680°C, the electrode to be coated was at a temperature of about 450°C, and the pressure of the coater was about 8 Pa (6 X $10^{-2}$ torr). CdTe coating times were about 90 sec.

The electrical properties of the cell were determined using simulated AM2 illumination, that is, light of an intensity of 75 mW/cm$^2$. The total forward resistance $R_D$ of Table II was measured from the slope of the I-V curves so obtained, of which $I_{sc}$ and $V_{oc}$ are stated in the table (short-circuit current and open-circuit voltage, respectively). From this, $R_c$, the contact resistance of the electrode to the CdTe layer, was estimated by subtracting the resistance of the Au barrier electrode, of the CdTe layer, and of the electrode, and then multiplying by the cell area (0.1 cm$^2$). Each of the subtracted resistances was estimated based upon measurements taken from a representative number of samples. The Au resistance is normally 20 to 45 ohms, the CdTe resistance about 25 ohms, and the electrode resistance about 20 ohms. The estimated error for the Rc values of Table II is $\pm$ 200%. With this error range, even the examples with the highest measured Rc values do not exceed a contact resistance of about 20 ohm-cm$^2$.

TABLE II

| Example | Dopant-oxide (thickness, $10^{-4}\mu m$ (A)) | Metal (thickness, $10^{-4}\mu m$ (A)) | Voc, mV | Isc, mA | $R_D$ $\Omega$ | $R_C$ $\Omega\text{-cm}^2$ |
|---|---|---|---|---|---|---|
| Control 1 | Nesatron (3000) | none | 443 | 0.89 | $\propto$ | >800 |
| Control 2 | Nesatron (3000) + $In_2O_3$(83) | none | 460 | 1.20 | $\propto$ | >800 |
| Control 3 | $In_2O_3$ (157) | Au(1233) | 350 | 1.10 | $\propto$ | >800 |
| Control 4 | $In_2O_3$ (102) | Ni(425) | 357 | 0.87 | $\propto$ | >800 |
| Control 5 | $In_2O_3$ (121) | Au(946) | 390 | 0.91 | $\propto$ | >800 |
| 3 | Nesatron (3000) | Cr(1160) | 428 | 1.09 | 79 | 1.14 |
| 4 | $In_2O_3$ (64) | Cr(1016) | 425 | 1.13 | 143 | 7.8 |
| 5 | $In_2O_3$ (139) | Cr(1101) | 435 | 0.95 | 97 | 3.2 |
| 6 | $In_2O_3$ (80) | Al(1218) | 470 | 0.88 | 79 | 1.4 |
| 7 | Nesatron (3000) | Cr(876) | 410 | 1.15 | 125 | 6 |
| 8 | Nesatron (3000) | Ti(850) | 420 | 1.07 | 84 | 1.9 |
| 9 | $In_2O_3$ (117) | Ti(931) | 450 | 1.17 | 143 | 7.8 |
| 10 | $Ga_2O_3$ (57) | Cr(763) | 440 | 0.98 | 88 | 2.3 |

Controls 3, 4 and 5 all involved the use of a "reducing" metal that is not capable of reducing $In_2O_3$, as is evident from the location of the oxide of that metal in Table I. The contact resistance for such controls was greater than 800 ohm-$cm^2$ (the maximum determinable value being 800 ohm-$cm^2$).

0080342

Claims:

1. A photosensitive element comprising a support(12) bearing an electrically conductive electrode and a layer of n-type or p-type CdTe(20) on the electrode,

characterized in that said electrode, said CdTe layer(20) or both thereof comprise

a) a material having an electronically active form capable of functioning as an n-type or p-type dopant for said n-type or p-type CdTe, respectively, and said electrode comprises

b) an oxidized metal or reaction product thereof which, in reduced form, is capable of reducing the oxidized form of said material to said electronically active form,

said electrode having, with said CdTe layer(20), a contact resistance that is no greater than about 20 ohm-cm$^2$.

2. An element according to Claim 1, wherein said electrode further comprises at least one of 1) said reduced form of said metal and 2) said oxidized form of said material.

3. An element according to Claim 1, wherein said electrode includes a first layer(14) comprising said oxidized form of said material and a second layer(16) comprising said reduced form of said metal, one of said layers being in contact with said CdTe layer(20),

said layers including an interfacial region(19) comprising said electronically active form of said material and said oxidized metal.

4. An element according to Claim 3, wherein said first layer(14) comprises the oxide of said material.

5. An element according to any one of the preceding claims, wherein said CdTe is n-type and said material is an element selected from In, Ga, B, Tl, Al, and Cd.

6. An element according to any one of the preceding claims, wherein said metal is an element selected from titanium, chromium, zirconium, aluminum, hafnium, tantalum, and magnesium.

7. An element according to Claim 1, wherein said electrode comprises an admixture of indium, oxidized titanium, and titanium.

8. A photovoltaic cell comprising a layer of n-type or p-type CdTe(20) sandwiched between an electrically conductive electrode on a support(12), and a barrier electrode(22) comprising a metal forming a photovoltaically active junction with said CdTe layer,

characterized in that the layer of n-type or p-type CdTe(20) and the electrically conductive electrode on a support(12) form a photosensitive element according to any one of the preceding claims.

9. A method of producing a photosensitive element comprising a support(12) bearing an electrically conductive electrode and a layer of n-type or p-type CdTe(20) on the electrode, characterized in that the method comprises the steps of

a) (i) forming two layers(14, 16) on a support, one of said layers(14) comprising an oxidized material which, in reduced form, is electronically active to function as an n-type or p-type dopant for said n-type or p-type CdTe, respectively; and the other layer(16) comprising a metal capable of reducing said oxidized material to said reduced form, or

(ii) forming a layer(19b) on a support said layer comprising a mixture of said oxidized material and said metal, and

b) forming on said layers(14, 16) or layer (19b), a layer of n-type or p-type CdTe(20).

10. A method according to Claim 9, wherein said steps include

c) heating said layer(19b) or layers(14, 16) and said CdTe layer(20) at a temperature and for a time sufficient to reduce at least some of said oxidized material to said reduced form and to diffuse at least some of said reduced form of said material into said CdTe layer(20).

0080342

1/1

FIG. 1

FIG. 2

FIG. 3